# EUROPÄISCHE PATENTSCHRIFT

(11) **EP 4 424 934 B1**
(45) Veröffentlichungstag und Bekanntmachung des Hinweises auf die Patenterteilung: **01.07.2026**
(21) Anmeldenummer: 24155316.3
(22) Anmeldetag: 01.02.2024
(51) Int. Cl.: E03C 1/042, H02G 3/12, F16L 5/08, H02G 3/14

(54) **ABDECKROSETTE UND EINBAUSET FÜR INSTALLATIONSANSCHLUSS**
COVERING ROSETTE AND INSTALLATION SET FOR INSTALLATION CONNECTION
ROSETTE DE RECOUVREMENT ET ENSEMBLE DE MONTAGE POUR CONNEXION D'INSTALLATION

(30) Priorität: 01.03.2023 DE 102023105107
(43) Veröffentlichungstag der Anmeldung: 04.09.2024
(73) Patentinhaber: Hansgrohe SE, 77761 Schiltach (DE)
(72) Erfinder: Armbruster, Stefan, 77756 Hausach (DE); Blattner, Joachim, 77716 Haslach (DE); Brendle, Elvira, 72186 Empfingen (DE); Dold, Florian, 77716 Hofstetten (DE); Kunz, Alexander, 78730 Lauterbach (DE); Lehmann, Günther, 77709 Oberwolfach (DE); Schmider, Jürgen, 77716 Haslach (DE)
(74) Vertreter: Patentanwälte Ruff, Wilhelm, Beier, Dauster & Partner mbB

(56) Entgegenhaltungen:
- EP-A1- 3 162 970
- DE-U1- 202012 100 198
- US-B1- 8 261 766

## Beschreibung

Die Erfindung bezieht sich auf eine Abdeckrosette zum Abdecken einer gebäudeseitigen Wandöffnung nach dem Oberbegriff des Anspruchs 1, insbesondere für ein wandeinbaubares sanitäres oder elektrisches Installations-Einbauset, sowie auf ein Installations-Einbauset zum Einbau in eine wandeingebaute, sanitäre oder elektrische Installationsanschlussbox, wobei das Installations-Einbauset einen Funktionsblock zum Einbau in die Installationsanschlussbox mit einem Grundkörper und einem daran gehaltenen Abdeckkörper aufweist.

Funktionsblöcke der oben genannten Art werden beispielsweise als sanitäre Funktionsblöcke in der Sanitärinstallationstechnik zum Anschließen von Sanitärkomponenten, wie Wasserauslaufarmaturen für Waschtische, Badewannen, Duschbrausen oder Küchenspülen oder diesen vorgelagerten sanitären Thermostat-, Mischer- und/oder Absperrventileinheiten, an gebäudeseitig vorinstallierte Wasserleitungsanschlüsse und in der Elektroinstallationstechnik als elektrische Funktionsblöcke zum Anschließen von elektrischen Einbaukomponenten, wie Steckdosen, Abzweigdosen, Sensoren, Aktoren, Lichtschalter etc., an gebäudeseitig vorinstallierte Elektroleitungsanschlüsse verwendet. Dazu wird der Funktionsblock in der Regel als eigenständige Baueinheit vorgefertigt und dann als solche Baueinheit an der vorgesehenen Einsatzstelle an einer Gebäudewand verbaut, i.e. montiert, im Fall eines sanitären Funktionsblocks z.B. an der Wand eines Duschraums, eines Badezimmers, einer Küche, einer Toilette etc.

Dabei wird der Funktionsblock mit seinem Grundkörper üblicherweise in einen gebäudewandseitigen Einbauraum eingefügt, der von einer wandeinbaubaren, d.h. einer zum Einbau in eine gebäudeseitige Wand eingerichteten, Installationsanschlussbox bereitgestellt ist. Typisch sind hierbei vor allem Unterputz-Ausführungen, bei denen die Installationsanschlussbox derart in eine Öffnung einer Gebäudewand eingebaut wird, dass sie vorderseitig möglichst bündig mit der fertiggestellten Gebäudewandfläche, z.B. einer verputzten Wandfläche oder einer Fliesenwandfläche, abschließt. Es versteht sich, dass es sich bei der Wand sowohl um eine eigentliche Wand als auch um einen Boden oder eine Decke eines Zimmers oder Raums eines Gebäudes, z.B. im Sanitärfall speziell eines Badezimmers oder Duschraums oder einer Küche, handeln kann. Der Grundkörper des Funktionsblocks kann in Sanitäranwendungen an einen als Schnittstelle zwischen gebäudeseitigen Installationsanschlüssen und dem Funktionsblock fungierenden Anschlusskörper der Box anschließen und je nach Anwendungsfall mit benötigten Fluidkanälen versehen und mit benötigten Sanitärkomponenten bestückt sein, wie z.B. Mischventilen, Umstellventilen und Absperrventilen.

Zur Montage wird in solchen Ausführungen die Installationsanschlussbox vor kompletter Fertigstellung der Wandfläche in einer Einbauöffnung der noch unfertigen Wand angebracht, so dass sie mit einer Seitenwandung über eine Soll-Oberfläche der fertigen Wand vorsteht, wobei sich diese Soll-Oberfläche z.B. durch eine abschließende Verfliesung der Wand oder Aufbringen einer anderweitigen Sichtoberfläche der fertigen Wand definiert. Nach Fertigstellung der Wand wird ein eventuell noch aus der Wand vorstehender Teil der Seitenwandung der Box in Höhe der Oberfläche der fertigen Wand abgetrennt oder bis zur Oberfläche der fertigen Wand zurückgeschoben. Anschließend wird der Funktionsblock mit seinem Grundkörper in die Box eingefügt.

**In** diesem Zusammenhang werden häufig Abdeckrosetten der eingangs genannten Art und ähnlicher Art dazu verwendet, einen verbleibenden Rand bzw. Spalt zwischen dem eingesetzten Funktionsblock und dem benachbarten Wandbereich um die Wandöffnung herum optisch zu verdecken und/oder gegen eindringendes Wasser abzudichten. Dazu wird die Abdeckrosette gegen den betreffenden Bereich der fertiggestellten Wandfläche angelegt.

Der am Grundkörper angebrachte Abdeckkörper des Funktionsblocks fungiert in entsprechenden Ausführungen selbst als Abdeckrosette und wird entsprechend gegen die fertige Wand zur Anlage gebracht und vorzugsweise zur Wand verspannt befestigt, um eine Abdichtung bereitzustellen. In alternativen Ausführungen wird eine Abdeckrosette als separates Bauteil wiederum vorzugsweise verspannt gegen die fertiggestellte Wand abdichtend angelegt und am Abdeckkörper des Funktionsblocks festgelegt.

Abdeckrosetten für diesen sanitären Anwendungszweck sind beispielsweise in der Offenlegungsschrift DE 40 34 898 A1 und der Gebrauchsmusterschrift DE 203 03 049 U1 offenbart.

Es ist auch bekannt, Abdeckrosetten in dieser oder ähnlichen Ausführungen der eingangs genannten Art für elektrische Wandinstallationseinbauten zu verwenden.

Gattungsgemäße Abdeckrosetten, d.h. solche nach dem Oberbegriff des Anspruchs 1, beinhalten einen inneren Rosettenkörper, der zur stationären wandseitigen Festlegung eingerichtet ist, einen äußeren Rosettenkörper zum Anbringen auf dem inneren Rosettenkörper und eine Befestigungsstruktur, mit welcher der äußere Rosettenkörper um einen vorgebbaren Winkelausgleichsbetrag begrenzt drehbeweglich um eine Rosettenlängsachse am inneren Rosettenkörper gehalten ist.

Eine derartige Abdeckrosette ist in der Offenlegungsschrift EP 3 162 970 A1 offenbart. Bei der dortigen Abdeckrosette umfasst die Befestigungsstruktur eine frei drehbare Clipsverbindung des äußeren am inneren Rosettenkörper sowie ein Schneckengetriebe mit einer wendelförmigen Kulissenbahn am inneren Rosettenkörper und einem in die Kulissenbahn eingreifenden Kulissennocken am äußeren Rosettenkörper. Das Schneckengetriebe begrenzt durch den begrenzten Bewegungsweg des Kulissennockens in der Kulissenbahn die relative Verdrehbarkeit der beiden Rosettenkörper gegeneinander.

Die Gebrauchsmusterschrift DE 20 2012 100 198 U1 offenbart eine sanitäre Befestigungsanordnung mit einem in einem Unterputzkasten untergebrachten Armaturengrundkörper und einem auf diesen aufsetzbaren und mit diesem über eine Bolzen-Langloch-Verbindung begrenzt drehbeweglich verbundenen Steuerkörper.

Die Patentschrift US 8.261.766 B1 offenbart das verdrehbare Anbringen eines äußeren Rosettenkörpers an einem inneren Rosettenkörper unter Verwendung einer speziellen Klauenverbindung ähnlich einer Bajonettverbindung.

Der Erfindung liegt als technisches Problem die Bereitstellung einer Abdeckrosette der eingangs genannten Art, die sich zum zuverlässigen und funktionell vorteilhaften, montagetoleranten Abdecken einer gebäudeseitigen Wandöffnung eignet, sowie eines Installations-Einbausets zum Einbau in eine wandeingebaute, sanitäre oder elektrische Installationsanschlussbox der eingangs genannten Art zugrunde.

Die Erfindung löst dieses Problem durch die Bereitstellung einer Abdeckrosette mit den Merkmalen des Anspruchs 1 und eines Installations-Einbausets mit den Merkmalen des Anspruchs 9.

Vorteilhafte Weiterbildungen der Erfindung sind in den Unteransprüchen angegeben, deren Wortlaut hiermit durch Verweis zum Bestandteil der Beschreibung gemacht wird. Dies schließt insbesondere auch alle Ausführungsformen der Erfindung ein, die sich aus den Merkmalskombinationen ergeben, die durch die Rückbezüge in den Unteransprüchen definiert sind.

Aufgrund seiner gattungsbildenden Merkmale besitzt die Abdeckrosette einen zumindest zweiteiligen Aufbau mit dem inneren und dem äußeren Rosettenkörper, wobei als innerer Rosettenkörper derjenige bezeichnet ist, der näher zur abzudeckenden gebäudeseitigen Wandöffnung platziert wird als der äußere Rosettenkörper, der näher zur Benutzerseite angeordnet wird, d.h. näher zum dem Benutzer zugänglichen Raum vor der Wandöffnung.

Unter der stationären wandseitigen Festlegung des inneren Rosettenkörpers ist vorliegend zu verstehen, dass dieser stationär, d.h. ortsfest bzw. unbeweglich, an einer gebäudeseitigen Wand anzubringen ist, sei es durch direkte Fixierung an dieser oder durch Fixierung an einem Bauteil, das seinerseits stationär mit der gebäudeseitigen Wand verbunden ist, wie z.B. an einer wandeingebauten Installationsanschlussbox oder an einer Komponente eines in die Box eingebauten Installations-Einbausets wie insbesondere an einem zugehörigen Funktionsblock.

Unter der begrenzt um die Rosettenlängsachse drehbeweglichen Halterung des äußeren Rosettenkörpers am inneren Rosettenkörper mittels der zugehörigen Befestigungsstruktur ist vorliegend zu verstehen, dass der äußere Rosettenkörper nach seiner Festlegung am inneren Rosettenkörper gegenüber diesem um den vorgegebenen Winkelausgleichsbetrag begrenzt drehbeweglich bleibt, d.h. weder stationär bzw. unbeweglich am inneren Rosettenkörper gehalten ist, noch gegenüber diesem unbegrenzt um eine volle Umdrehung von 360° oder mehr verdreht werden kann.

Die begrenzte Drehbeweglichkeit des am inneren Rosettenkörper gehaltenen äußeren Rosettenkörpers kann insbesondere dazu genutzt werden, eine Fertigungs- und/oder Montagetoleranz bereitzustellen, um entsprechende Ungenauigkeiten auszugleichen bzw. zu kompensieren, die andernfalls dazu führen könnten, dass der äußere Rosettenkörper, der typischerweise für den Benutzer sichtbar bleibt, bezüglich der Rosettenlängsachse eine Winkellage einnimmt, die von einer gewünschten Soll-Winkellage abweicht. So ist es beispielsweise bei einem viereckigen äußeren Rosettenkörper meist gewünscht, dass dessen Seitenkanten in der endmontierten Position an der gebäudeseitigen Wand möglichst genau horizontal bzw. vertikal verlaufen.

Aufgrund von Fertigungs- und/oder Montageungenauigkeiten bei der Herstellung der gebäudeseitigen Wandöffnung, dem Einfügen einer Installationsanschlussbox, der Fertigstellung der Wandoberfläche z.B. durch Verfliesen oder Verputzen und dem Einbau eines Funktionsblocks in die Installationsanschlussbox kann es zu derartigen Abweichungen der Ist-Winkellage des äußeren Rosettenkörpers von der Soll-Winkellage kommen. Dabei treten schon Winkelabweichungen von ca. 1° oder von nur einigen wenigen Grad meist störend in Erscheinung.

Durch entsprechende Vorgabe des Winkelausgleichsbetrags kann der äußere Rosettenkörper nach Anbringen am inneren Rosettenkörper gegenüber diesem so weit verdreht werden, dass der äußere Rosettenkörper auch dann seine gewünschte Soll-Winkellage in Bezug auf die Rosettenlängsachse einnimmt, wenn der innere Rosettenkörper um eine gewisse Winkelabweichung gegenüber der Soll-Winkellage fehlmontiert ist. Zweckmäßigerweise wird hierfür der Winkelausgleichsbetrag, um den der äußere Rosettenkörper um die Rosettenlängsachse gegenüber dem inneren Rosettenkörper begrenzt drehbeweglich ist, mindestens so groß oder etwas größer gewählt als die maximal zu erwartende Winkelabweichung des inneren Rosettenkörpers aufgrund solcher Fertigungs- und/oder Montageungenauigkeiten.

Somit ermöglicht die erfindungsgemäße Abdeckrosette in sehr montagefreundlicher Weise ein zuverlässiges Abdecken der betreffenden gebäudeseitigen Wandöffnung mit exakter Einhaltung der gewünschten Winkellage des äußeren Rosettenkörpers in Bezug auf die Rosettenlängsachse, ohne dass der Monteur bzw. Installateur hierzu Nacharbeiten an der gebäudeseitigen Wandöffnung vornehmen und/oder eine bereits montierte Installationsanschlussbox und/oder einen bereits darin montierten Funktionsblock wieder demontieren und neu montieren muss. Vielmehr kann er die Wandöffnung samt eingebauter Box und montiertem Funktionsblock unverändert belassen und braucht lediglich den äußeren Rosettenkörper in seine gewünschte Soll-Winkellage gegenüber dem inneren Rosettenkörper zu drehen.

Vorzugsweise erstreckt sich der äußere Rosettenkörper radial über den inneren Rosettenkörper hinaus. Dadurch deckt der äußere Rosettenkörper den inneren Rosettenkörper körperlich bzw. optisch nach außen hin ab, d.h. zur Sichtseite hin bzw. in Richtung senkrecht zur Rosettenebene und damit einer Ebene einer gebäudeseitigen Wand, an der sich die Wandöffnung befindet, in die das Einbauset eingebaut wird. In entsprechenden Ausführungen erstreckt sich der äußere Rosettenkörper entlang seines gesamten Umfangs radial über den inneren Rosettenkörper hinaus, so dass der innere Rosettenkörper vollständig vom äußeren Rosettenkörper abgedeckt wird, wobei die Wandöffnung je nach Ausführung der Abdeckrosette schon vom inneren Rosettenkörper und in jedem Fall vom äußeren Rosettenkörper vollständig abgedeckt wird, wie es Zweck der Abdeckrosette ist.

Erfindungsgemäß umfasst die Befestigungsstruktur eine um den vorgebbaren Winkelausgleichsbetrag begrenzt drehbewegliche Schnappverbindung des äußeren Rosettenkörpers am inneren Rosettenkörper. Der Begriff Schnappverbindung ist hierbei vorliegend in seinem breiten Sinn zu verstehen, d.h. er beinhaltet auch z.B. Clips- und Rastverbindungen mit Schnappverhalten. Dies stellt eine mit relativ geringem Herstellungsaufwand verbundene, funktionell zuverlässige und montagefreundliche Realisierung der Befestigungsstruktur dar.

Gemäß einem Aspekt der Erfindung umfasst die Schnappverbindung mindestens eine vom äußeren oder inneren Rosettenkörper axial abstehende Schnappnase und eine mit dieser durchsteckend zusammenwirkende, schlitzförmige Schnappöffnung im anderen Rosettenkörper, wobei in Rosettenumfangsrichtung die Erstreckung der Schnappöffnung um den vorgebbaren Winkelausgleichsbetrag größer ist als die Erstreckung der Schnappnase. Indem die Winkelerstreckung der jeweiligen Schnappöffnung um den vorgebbaren Winkelausgleichsbetrag größer gewählt ist als die Winkelerstreckung der zugeordneten Schnappnase, bleibt der äußere Rosettenkörper nach dem einschnappenden Durchstecken der einen oder mehreren Schnappnasen in die jeweilige Schnappöffnung des inneren Rosettenkörpers um den gewünschten Winkelausgleichsbetrag gegenüber dem inneren Rosettenkörper drehbeweglich.

Gemäß einem anderen Aspekt der Erfindung umfasst die Schnappverbindung mindestens eine vom äußeren oder inneren Rosettenkörper radial abstehende Schnappnase und eine mit dieser hinterrastend zusammenwirkende Schnappkante am anderen Rosettenkörper, wobei in Rosettenumfangsrichtung seitlich einer Rückseite der Schnappkante mindestens ein Drehbegrenzungsanschlag für die Schnappnase ausgebildet ist. Diese Realisierung der Schnappverbindung eignet sich insbesondere für Fälle, bei denen die beiden Rosettenkörper koaxiale, aneinandergrenzende radial innere oder radial äußere Ränder besitzen, an denen dann herstellungstechnisch einfach und funktionell zuverlässig die einen oder mehreren Schnappnasen und die jeweils zugehörige Schnappkante ausgebildet sein können. Zum Zusammenfügen bzw. Zusammenschnappen von äußerem und innerem Rosettenkörper wird die Schnappnase beim Montieren radial elastisch gebogen und schnappt dann nach Erreichen der Schnappkantenrückseite rastend hinter diese in ihre Halteposition zurück. Der Drehbegrenzungsanschlag definiert in diesem Fall das Maß an begrenzter Drehbeweglichkeit des äußeren Rosettenkörpers gegenüber dem inneren Rosettenkörper gemäß dem hierzu vorgegebenen Winkelausgleichsbetrag.

In einer Weiterbildung der Erfindung sichert die Befestigungsstruktur die jeweilige Drehstellung des äußeren Rosettenkörpers am inneren Rosettenkörper durch eine nutzerüberwindbare Kraftschlussverbindung. Dies stellt eine mit vergleichsweise geringem Herstellungsaufwand realisierbare und funktionell vorteilhafte Ankopplung des äußeren Rosettenkörpers an den inneren Rosettenkörper dar. Die Kraftschlussverbindung verhindert, dass sich der äußere Rosettenkörper selbsttätig gegenüber dem inneren Rosettenkörper aus seiner gewünschten Soll-Winkellage herausdreht. Andererseits kann die Kraftschlussverbindung vom Benutzer überwunden werden, um den äußeren Rosettenkörper bei der Montage nach Anbringung am inneren Rosettenkörper bei Bedarf gegenüber dem inneren Rosettenkörper zu verdrehen, um ihn aus einer abweichenden Winkellage heraus in seine Soll-Winkellage zu bringen. In alternativen Ausführungen beinhaltet die Befestigungsstruktur andere herkömmliche Sicherungsmittel bezüglich eines unerwünschten Verdrehens des äußeren Rosettenkörpers gegenüber dem inneren Rosettenkörper, die vom Benutzer bei Bedarf überwunden werden können, z.B. eine nutzerüberwindbare Formschlussverbindung, wie beispielsweise eine entsprechende Rastverbindung.

In einer Weiterbildung der Erfindung ist der innere Rosettenkörper zur stationären Festlegung an einem Funktionsblock eines wandeinbaubaren sanitären Installations-Einbausets eingerichtet. Dies stellt für viele Anwendungsfälle eine vorteilhafte Kombination der Abdeckrosette mit einem Funktionsblock eines wandeinbaubaren sanitären Installations-Einbausets dar. Alternativ kann der innere Rosettenkörper beispielsweise direkt an einer sanitären oder elektrischen Installationsanschlussbox oder an der gebäudeseitigen Wand im Bereich um die betreffende Wandöffnung herum fixiert sein.

In einer Weiterbildung der Erfindung beträgt der Winkelausgleichsbetrag zwischen 2° und 10° und setzt sich aus einem ersten Winkelausgleichsbetragsanteil in der einen Drehrichtung um die Rosettenlängsachse gegenüber einer vorgegebenen Sollwinkellage und einem zweiten Winkelausgleichsbetragsanteil in der anderen Drehrichtung um die Rosettenlängsachse gegenüber der vorgegebenen Sollwinkellage zusammen. Dies ist eine für die meisten Anwendungsfälle günstige Wahl des Winkelausgleichsbetrags. Je nach Bedarf können die beiden Winkelausgleichsbetragsanteile auf den beiden Seiten der Sollwinkellage gleich groß, z.B. jeweils ca. 2° oder ca. 3° oder ca. 4° oder unterschiedlich groß sein, z.B. ca. 3° auf der einen und ca. 5° auf der anderen Winkelseite der Sollwinkellage. Dabei hat die Wahl gleich großer Winkelausgleichsbetragsanteile im Allgemeinen den Vorteil, dass Montagetoleranzen beidseits der Sollwinkellage in gleich großem Maß ausgeglichen werden können. Für entsprechende Anwendungen ist es günstig, wenn der Winkelausgleichsbetrag im Bereich zwischen 4° und 8° liegt. In alternativen Ausführungen liegt der Winkelausgleichsbetrag unter 2° oder über 10°, wenn dies für entsprechende Anwendungen zweckmäßig ist.

In einer Weiterbildung der Erfindung steht die Schnappnase axial von einer Rückseite des äußeren Rosettenkörpers ab, und die Schnappöffnung ist am inneren Rosettenkörper ausgebildet. Die Verbindung der beiden Rosettenkörper kann auf diese Weise sehr einfach von der Sichtseite, d.h. der Benutzerseite, aus optisch unsichtbar realisiert werden. Der äußere Rosettenkörper kann mit der oder den rückseitigen Schnappnasen in die jeweilige Schnappöffnung am inneren Rosettenkörper eingeschnappt und dadurch an diesem gehalten werden.

In einer Weiterbildung der Erfindung ist die Schnappöffnung von einer Dichtungsstruktur umrandet. Dies ermöglicht in einfacher Weise bei Bedarf eine Abdichtung der Schnappöffnung gegen unerwünscht eindringendes Wasser. Gleichzeitig kann die Dichtungsstruktur, wenn gewünscht, zur Bereitstellung der erwähnten nutzerüberwindbaren Kraftschlussverbindung für die Befestigungsstruktur genutzt werden, in diesem Fall in Form einer Reibschlussverbindung der Dichtungsstruktur einerseits mit der durch die Schnappöffnung durchgesteckten Schnappnase andererseits. Bei Bedarf kann sich die Dichtungsstruktur auch auf andere Bereiche des inneren bzw. äußeren Rosettenkörpers außerhalb der Schnappöffnung erstrecken. So kann sich in entsprechenden Ausführungen die Dichtungsstruktur umfangsseitig um den gesamten inneren und/oder äußeren Rosettenkörper herum und zusätzlich um die jeweilige Schnappöffnung herum erstrecken. In alternativen Ausführungen bleibt die Schnappöffnung ohne umrandende Dichtung, wenn dies für entsprechende Anwendungen nicht erforderlich ist.

In einer Weiterbildung der Erfindung steht die Schnappnase radial nach innen von einem radial inneren Rand des äußeren Rosettenkörpers ab, und die Schnappkante ist an einem radial äußeren Rand des inneren Rosettenkörpers ausgebildet. In diesem Fall nimmt der äußere Rosettenkörper an dem radial inneren Rand den inneren Rosettenkörper an dem radial äußeren Rand auf, und passend dazu sind die eine oder mehreren Schnappnasen am äußeren Rosettenkörper und die jeweils zugeordnete Schnappkante am inneren Rosettenkörper ausgebildet. In alternativen Ausführungen können die Schnappnasen zum Beispiel radial nach außen von einem radial äußeren Rand des inneren Rosettenkörpers abstehen und die jeweilige Schnappkante an einem radial inneren Rand des äußeren Rosettenkörpers ausgebildet sein.

In einer Weiterbildung der Erfindung ist am radial äußeren Rand des inneren Rosettenkörpers axial vor der Schnappkante eine Aufschnappkontur ausgebildet. Die Aufschnappkontur kann das radiale Biegen der Schnappnase unterstützen, bevor die entsprechend gebogene Schnappnase dann hinter die Schnappkante verrastend zurückschnappt. In alternativen Ausführungen kann eine solche Aufschnappkontur am radial äußeren Rand des inneren Rosettenkörpers axial vor der Schnappkante fehlen und stattdessen z.B. eine Aufschnappkontur nur an der Schnappnase vorgesehen sein oder insgesamt fehlen.

Das zum Einbau in eine wandeingebaute, sanitäre oder elektrische Installationsanschlussbox eingerichtete, erfindungsgemäße Installations-Einbauset beinhaltet die erfindungsgemäße Abdeckrosette, wobei zumindest der innere Rosettenkörper Bestandteil des Abdeckkörpers des zum Einbau in die Installationsanschlussbox eingerichteten Funktionsblocks ist.

Dieses Einbauset ist aufgrund seiner speziellen Abdeckrosette insbesondere für wandeinbaubare Installationsanschlussboxen vorteilhaft verwendbar, bei denen die Box in eine Öffnung bzw. Aufnahme einer gebäudeseitigen Wand, zu der gebäudeseitige sanitäre und/oder elektrische Installationsanschlüsse geführt sind, eingesetzt wird und nach Fertigstellen der Wand der Funktionsblock mit seinem Grundkörper in den von der Box bereitgestellten Einbauraum eingefügt wird und der Abdeckkörper des Funktionsblocks gegen die Wand zur Anlage gebracht wird. Dabei können Fertigungsungenauigkeiten bei der Herstellung der Wandöffnung, beim Verlegen der in der Wandöffnung endenden sanitären oder elektrischen Installationsanschlüsse und beim Montieren der Box und des Funktionsblocks dazu führen, dass die Box und/oder der Funktionsblock und insbesondere dessen gegen die Wand angelegter Abdeckkörper in ihrer tatsächlichen Winkellage in Bezug auf eine zur Wandoberfläche senkrechte Bezugsachse, wie eine Längsachse der Box bzw. des Funktionsblocks, von ihrer gewünschten Sollwinkellage abweichen. Die Sollwinkellage ist typischerweise eine Lage, bei der geradlinige Seitenkanten des Abdeckkörpers und/oder einer am Funktionsblock zu montierenden Abdeckrosette und/oder von daran montierten Komponenten, wie Bedienelementen, genau horizontal bzw. vertikal verlaufen. Ein demgegenüber schräger Verlauf dieser Seitenkanten ist im Allgemeinen schon aus gestalterisch ästhetischen Gründen unerwünscht.

Dem trägt die erfindungsgemäße Abdeckrosette des Einbausets Rechnung, indem sie es wie oben erläutert ermöglicht, den äußeren Rosettenkörper um die Rosettenlängsachse um ein gewünschtes Maß gegenüber dem inneren Rosettenkörper zu verdrehen, so dass der äußere Rosettenkörper seine gewünschte Soll-Winkellage einnehmen kann, auch wenn diesbezüglich die Box und/oder der Funktionsblock und insbesondere der innere Rosettenkörper fehlmontiert sind, d.h. nicht die zugedachte Soll-Winkellage bezüglich der senkrecht zur Gebäudewand verlaufenden Rosettenlängsachse einnehmen.

In einer Weiterbildung der Erfindung ist der äußere Rosettenkörper ein äußerer Bestandteil des Funktionsblock-Abdeckkörpers und weist eine Befestigungsstruktur zum Anbringen eines Sicht-/Bedienoberflächenkörpers auf. In diesem Fall fungiert der äußere Rosettenkörper als Träger für den darauf anzubringenden Sicht-/Bedienoberflächenkörper, wobei letzterer dann die für den Benutzer in der Regel einzig sichtbar bleibende Komponente des Installations-Einbausets darstellt, die typischerweise zugehörige Bedienschnittstellen bzw. Bedienelemente beinhaltet, wie Drehgriffe, Drucktasten, Bediensymbolelemente, Bedienanzeigeelemente etc.

In einer alternativen Weiterbildung der Erfindung ist der äußere Rosettenkörper als ein Sicht-/Bedienoberflächenkörper ausgebildet. In diesem Fall fungiert der äußere Rosettenkörper selbst als Sicht-/Bedienoberflächenkörper, der wie gesagt typischerweise das äußerste, abschließende, normalerweise für den Benutzer einzig sichtbare Element des Installations-Einbausets bildet und mit den oben erwähnten Bedien-/Anzeigemitteln ausgestattet sein kann.

Vorteilhafte Ausführungsformen der Erfindung sind in den Zeichnungen dargestellt. Diese und weitere Ausführungsformen der Erfindung werden nachfolgend näher erläutert. Hierbei zeigen:
- Fig. 1: eine perspektivische Explosionsansicht eines Installations-Einbausets zum Einbau in eine wandeingebaute, sanitäre Installationsanschlussbox mit einem Funktionsblock und einer Abdeckrosette mit innerem und äußerem Rosettenkörper,
- Fig. 2: eine Perspektivansicht des Einbausets von Fig. 1,
- Fig. 3: eine Seitenansicht des Einbausets von Fig.1,
- Fig. 4: eine Draufsicht von hinten auf die Abdeckrosette als Schnittansicht längs einer Linie **IV-IV** in Fig. 3 mit dem äußeren Rosettenkörper in einer Sollwinkellage,
- Fig. 5: die Ansicht von Fig. 4 mit dem äußeren Rosettenkörper in einer gegenüber der Sollwinkellage in einer ersten Drehrichtung verdrehten Winkellage,
- Fig. 6: die Ansicht von Fig. 4 mit dem äußeren Rosettenkörper in einer gegenüber der Sollwinkellage zur ersten entgegengesetzten, zweiten Drehrichtung verdrehten Winkellage,
- Fig. 7: eine perspektivische Draufsicht auf eine Rückseite des äußeren Rosettenkörpers,
- Fig. 8: eine Detaillängsschnittansicht eines Schnappnasenverbindungsbereichs der Abdeckrosette,
- Fig. 9: eine perspektivische Explosionsansicht eines weiteren Installations-Einbausets zum Einbau in eine wandeingebaute, sanitäre Installationsanschlussbox mit einem Funktionsblock und einer Abdeckrosette mit innerem und äußerem Rosettenkörper,
- Fig. 10: eine Perspektivansicht des Einbausets von Fig. 9,
- Fig. 11: eine Längsschnittansicht der Abdeckrosette des Einbausets von Fig. 10,
- Fig. 12: eine Draufsicht von hinten auf die Abdeckrosette des Einbausets von Fig. 10 mit dem äußeren Rosettenkörper in einer Sollwinkellage entsprechend Fig. 4,
- Fig. 13: eine vergrößerte Ausschnittansicht eines Bereichs XIII in Fig. 12,
- Fig. 14: eine perspektivische Ansicht des Bereichs XIII in Fig. 12,
- Fig. 15: die Ansicht von Fig. 12 mit dem äußeren Rosettenkörper in einer gegenüber der Sollwinkellage in einer ersten Drehrichtung verdrehten Winkellage,
- Fig. 16: die Ansicht von Fig. 13 mit dem äußeren Rosettenkörper in der gegenüber der Sollwinkellage verdrehten Winkellage von Fig. 15,
- Fig. 17: die Ansicht von Fig. 12 mit dem äußeren Rosettenkörper in einer gegenüber der Sollwinkellage zur ersten entgegengesetzten, zweiten Drehrichtung verdrehten Winkellage und
- Fig. 18: die Ansicht von Fig. 13 mit dem äußeren Rosettenkörper in der gegenüber der Sollwinkellage verdrehten Winkellage von Fig. 17.

In den Figuren ist die erfindungsgemäße Abdeckrosette in zwei exemplarischen Realisierungen veranschaulicht. Sie dient zum Abdecken einer gebäudeseitigen Wandöffnung, insbesondere für ein wandeinbaubares sanitäres oder elektrisches Installations-Einbauset. Konkret gezeigt ist die Verwendung für sanitäre Einbausets, alternativ ist die Abdeckrosette in gleicher Weise für wandeinbaubare elektrische Installations-Einbausets von ansonsten herkömmlicher Art verwendbar.

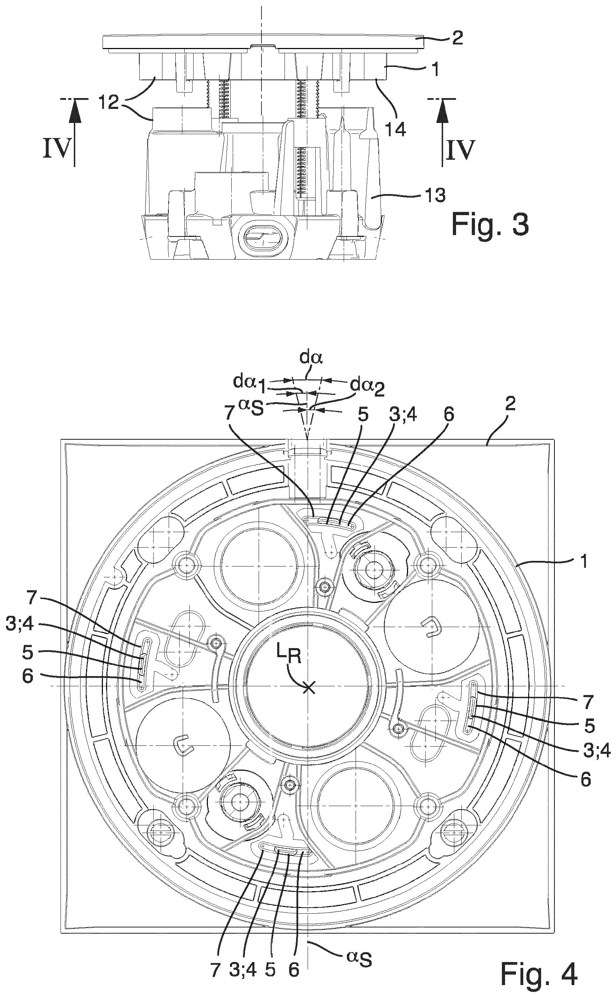

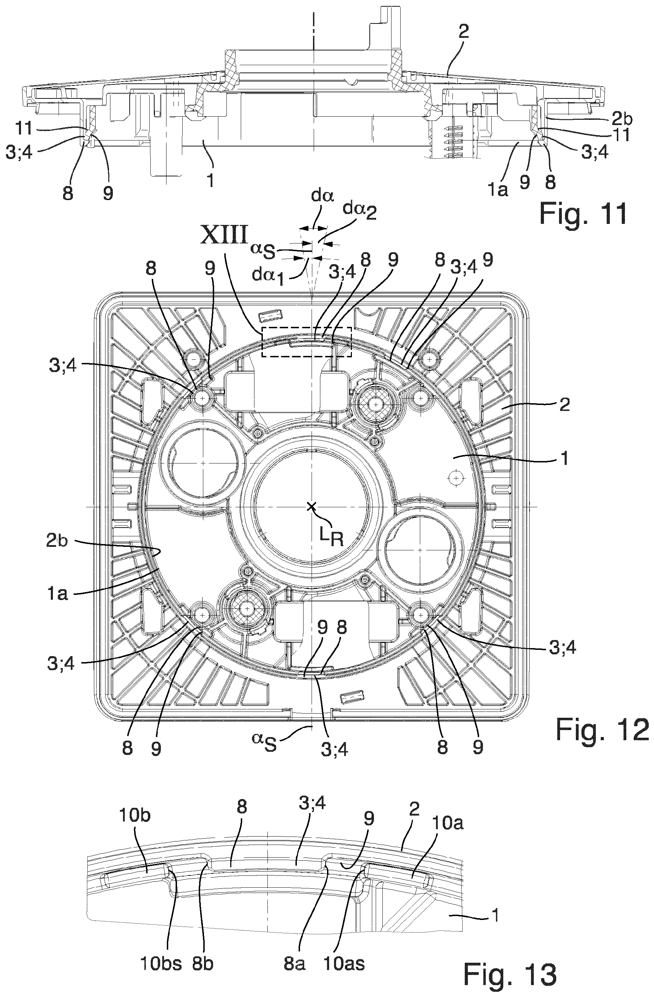

Wie aus den Figuren ersichtlich, beinhaltet die Abdeckrosette einen inneren Rosettenkörper 1, der zur stationären wandseitigen Festlegung eingerichtet ist, einen äußeren Rosettenkörper 2 zum Anbringen auf dem inneren Rosettenkörper 1 sowie eine Befestigungsstruktur 3, mit welcher der äußere Rosettenkörper 2 um einen vorgebbaren, exemplarisch in den Fig. 4 und 12 markierten Winkelausgleichsbetrag dα begrenzt drehbeweglich um eine Rosettenlängsachse L_{R} am inneren Rosettenkörper 1 gehalten ist. Dabei ist die Rosettenlängsachse L_{R} wie in solchen Anwendungen üblich im Wesentlichen senkrecht zur angrenzenden Wandoberfläche der gebäudeseitigen Wandöffnung orientiert.

In entsprechenden Ausführungen deckt, wie im gezeigten Beispiel, der äußere Rosettenkörper 2 den inneren Rosettenkörper 1 körperlich bzw. optisch nach außen hin vollständig ab, indem er sich radial allseitig über diesen hinaus erstreckt.

In vorteilhaften Ausführungsformen sichert die Befestigungsstruktur 3, wie in den gezeigten Beispielen, die jeweilige Drehstellung des äußeren Rosettenkörpers 2 am inneren Rosettenkörper 1 durch eine nutzerüberwindbare Kraftschlussverbindung.

In entsprechenden Ausführungen ist der innere Rosettenkörper 1, wie in den gezeigten Beispielen, zur stationären Festlegung an einem Funktionsblock eines wandeinbaubaren sanitären Installations-Einbausets eingerichtet.

In entsprechenden Realisierungen beträgt der Winkelausgleichsbetrag dα zwischen 2° und 10°, was für den damit beabsichtigten Ausgleich von Fertigungs- und/oder Montageungenauigkeiten in aller Regel ausreicht. In vielen Fällen wird für den Winkelausgleichsbetrag dα ein Wert zwischen 4° und 8° gewählt. In den gezeigten Beispielen beträgt der Winkelausgleichsbetrag dα ca. 6°.

Der Winkelausgleichsbetrag dα setzt sich hierbei aus einem ersten Winkelausgleichsbetragsanteil dα1 in der einen Drehrichtung um die Rosettenlängsachse L_{R} gegenüber einer vorgegebenen Soll-Winkellage α_{S} des äußeren Rosettenkörpers 2 und einem zweiten Winkelausgleichsbetragsanteil dα2 in der anderen Drehrichtung um die Rosettenlängsachse L_{R} gegenüber der vorgegebenen Soll-Winkellage α_{S} zusammen, wie beispielsweise in den Fig. 4 und 12 eingezeichnet. Es versteht sich aus dieser Definition, dass der Winkelausgleichsbetrag dα gleich der Summe der beiden Winkelausgleichsbetragsanteile dα1, dα2 ist, d.h. dα=dα1+dα2. Die Soll-Winkellage α_{S} kann dabei insbesondere einer Winkellage des äußeren Rosettenkörpers 2 entsprechen, in der dieser bei der gezeigten rechteckigen Außenform mit seinen vier Seitenkanten horizontal bzw. vertikal an der betreffenden gebäudeseitigen Wandöffnung ausgerichtet ist. Je nach Bedarf können die beiden Winkelausgleichsbetragsanteile dα1, dα2 gleich groß oder unterschiedlich groß sein und im Allgemeinen einen beliebigen Wert zwischen null und dα haben. In den gezeigten Beispielen sind sie gleich groß gewählt und betragen jeweils ca. 3°.

Erfindungsgemäß umfasst die Befestigungsstruktur 3, wie in den gezeigten Beispielen, eine um den vorgebbaren Winkelausgleichsbetrag dα begrenzt drehbewegliche Schnappverbindung 4 des äußeren Rosettenkörpers 2 am inneren Rosettenkörper 1. Die Schnappverbindung 4 hält den äußeren Rosettenkörper 2 am inneren Rosettenkörper 1 in axialer Richtung fest, während sie eine Verdrehung des äußeren Rosettenkörpers 2 gegenüber dem inneren Rosettenkörper 1 um die Rosettenlängsachse L_{R} in dem durch den Winkelausgleichsbetrag dα definierten Maß begrenzt zulässt.

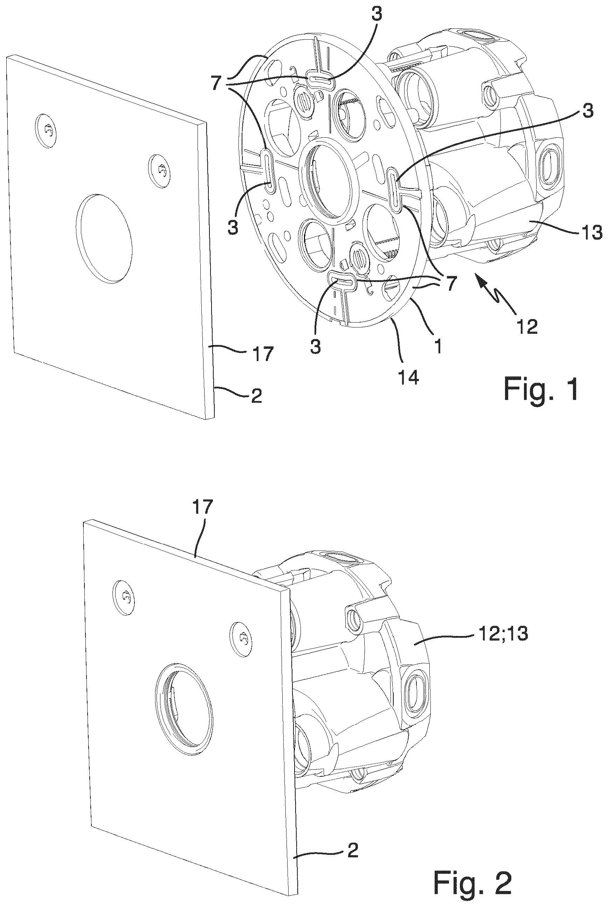

In entsprechenden Ausführungsformen umfasst die Schnappverbindung 4, wie im Ausführungsbeispiel der Fig. 1 bis 8, mindestens eine vom äußeren Rosettenkörper 2 oder vom inneren Rosettenkörper 1, im gezeigten Beispiel vom äußeren Rosettenkörper 2, axial abstehende Schnappnase 5 und eine mit dieser durchsteckend zusammenwirkende, schlitzförmige Schnappöffnung 6 im anderen Rosettenkörper 1, 2, im gezeigten Beispiel im inneren Rosettenkörper 1. Im gezeigten Beispiel der Fig. 1 bis 8 beinhaltet die Schnappverbindung 4 vier Schnappnasen 5, wie beispielsweise aus den Fig. 4 bis 7 ersichtlich, und vier korrespondierende Schnappöffnungen 6 im inneren Rosettenkörper 1, wie beispielsweise aus den Fig. 1 und 4 bis 6 ersichtlich.

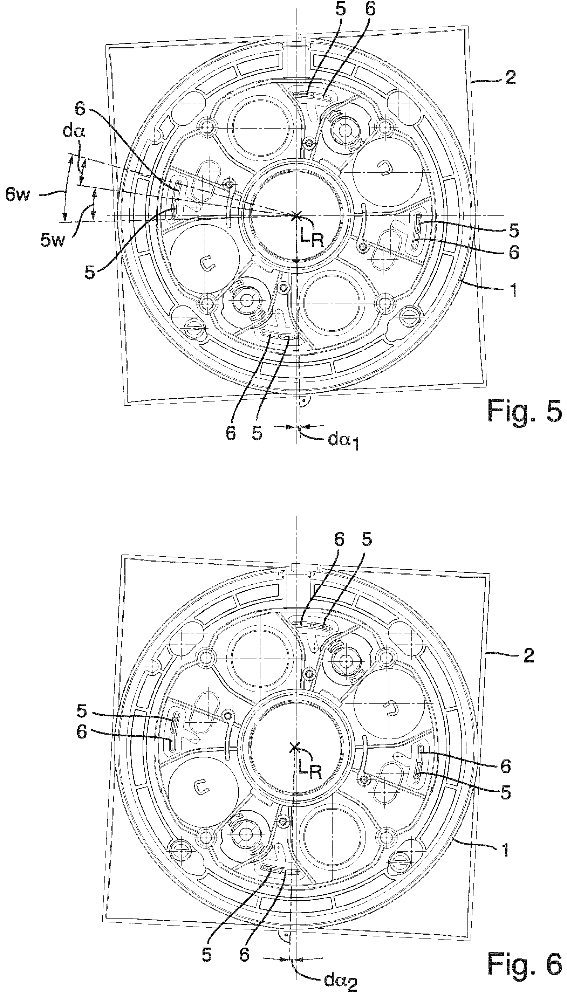

Dabei ist in Rosettenumfangsrichtung, d.h. in Richtung der Drehbeweglichkeit der Schnappverbindung 4 um die Rosettenlängsachse L_{R}, eine Winkelerstreckung 6w der jeweiligen Schnappöffnung 6 um den vorgebbaren Winkelausgleichsbetrag dα größer als eine Winkelerstreckung 5w der Schnappnase 5, wie in Fig. 5 exemplarisch zu einem der vier Paare von Schnappnase 5 und Schnappöffnung 6 gezeigt.

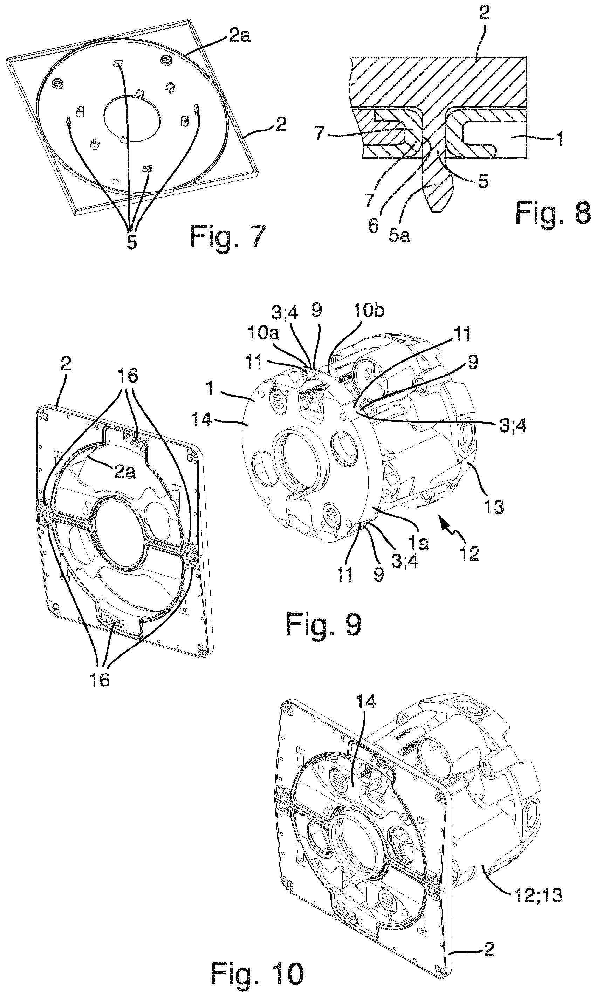

In entsprechenden Realisierungen steht die jeweilige Schnappnase 5, wie im Ausführungsbeispiel der Fig. 1 bis 8, axial von einer Rückseite 2a des äußeren Rosettenkörpers 2 ab, wie aus Fig. 7 ersichtlich, und die jeweilige Schnappöffnung 6 ist am inneren Rosettenkörper 1 ausgebildet.

Im Querschnitt kann die jeweilige Schnappnase 5 optional, wie im gezeigten Beispiel und aus Fig. 8 ersichtlich, einen verbreiterten Kopfbereich 5a aufweisen, der dazu beiträgt, dass die Schnappnase 5 leicht und sicher in die Schnappöffnung 6 hinein und durch diese hindurch gelangt, um damit den äußeren Rosettenkörper 2 axial am inneren Rosettenkörper 1 festzuhalten. Zudem kann das Einfügen der Schnappnase 5 in die Schnappöffnung 6 durch eine konisch verjüngte Gestaltung des Kopfbereichs 5a der Schnappnase 5 erleichtert werden, wie ebenfalls im Beispiel der Fig. 1 bis 8 realisiert und in Fig. 8 zu erkennen.

In vorteilhaften Ausführungen ist die jeweilige Schnappöffnung 6, wie im Ausführungsbeispiel der Fig. 1 bis 8, von einer Dichtungsstruktur 7 umrandet. Im gezeigten Beispiel der Fig. 1 bis 8 erstreckt sich die Dichtungsstruktur 7 zusätzlich auch in einem Dichtbereich des inneren Rosettenkörpers 1 außerhalb der jeweiligen Schnappöffnung 6, vorzugsweise insbesondere entlang eines radial äußeren Randbereichs des inneren Rosettenkörpers 1, wie in Fig. 7 gezeigt.

Dadurch kann die Dichtungsstruktur 7 eine ihr jeweils zugedachte Abdichtfunktion erfüllen, insbesondere zur Vermeidung des Eindringens von Wasser in die jeweilige Schnappöffnung bzw. insgesamt in den Bereich zwischen dem inneren Rosettenkörper 1 und dem äußeren Rosettenkörper 2. Des Weiteren kann die Dichtungsstruktur 7 im Bereich der Umrandung der jeweiligen Schnappöffnung 6 zur Bereitstellung der oben erwähnten, nutzerüberwindbaren Kraftschlussverbindung beitragen, mit der die Befestigungsstruktur 3 verhindert, dass sich der äußere Rosettenkörper 2 unbeabsichtigt gegenüber dem inneren Rosettenkörper 1 verdreht. Dazu kann sich die Dichtungsstruktur 7 reibschlüssig gegen die durchgesteckte Schnappnase 5 anlegen, wie beispielsweise aus Fig. 8 zu erkennen.

In vorteilhaften Ausführungsformen umfasst die Schnappverbindung 4, wie im gezeigten Ausführungsbeispiel der Fig. 9 bis 18, mindestens eine vom äußeren Rosettenkörper 2 oder vom inneren Rosettenkörper 1, im gezeigten Beispiel vom äußeren Rosettenkörper 2, radial abstehende Schnappnase 8 und eine mit dieser hinterrastend zusammenwirkende Schnappkante 9 am anderen Rosettenkörper 1, 2, im gezeigten Beispiel am inneren Rosettenkörper 1. Im gezeigten Beispiel der Fig. 9 bis 18 beinhaltet die Schnappverbindung 4 sechs radial abstehende Schnappnasen 8 am äußeren Rosettenkörper 2 und sechs korrespondierende Schnappkanten 9 am inneren Rosettenkörper 1, wie beispielsweise aus den Fig. 12, 15 und 17 ersichtlich.

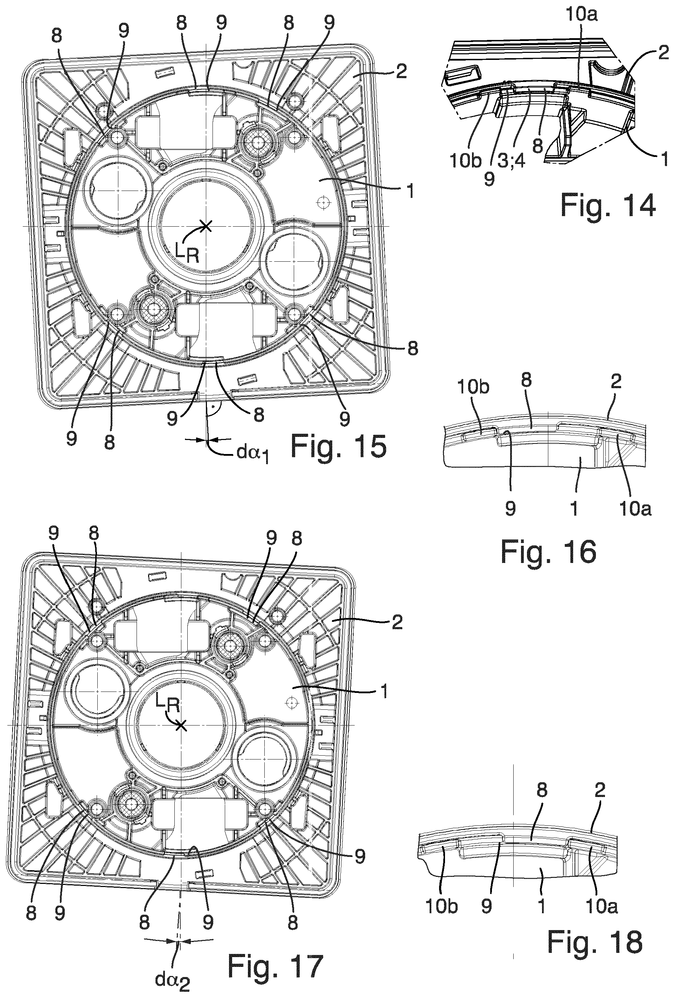

In Rosettenumfangsrichtung ist seitlich einer Rückseite der Schnappkante 9 mindestens ein Drehbegrenzungsanschlag 10a, 10b für die Schnappnase 8 ausgebildet. Im gezeigten Beispiel ist ein Paar seitlicher Drehbegrenzungsanschläge 10a, 10b für eines der sechs Paare von Schnappnase 8 und Schnappkante 9 vorgesehen, wie beispielsweise aus den Fig. 13 und 14 ersichtlich. Hierbei fungieren zugewandte Seiten 8a, 10as bzw. 8b, 10bs der Schnappnase 8 einerseits und des jeweiligen Drehbegrenzungsanschlags 10a, 10b als zusammenwirkende, d.h. gegeneinander zur Anlage kommende Anschlagflächen, wie aus Fig. 13 ersichtlich.

In entsprechenden Realisierungen steht die jeweilige Schnappnase 8, wie im Beispiel der Fig. 9 bis 18, radial nach innen von einem radial inneren Rand 2b des äußeren Rosettenkörpers 2 ab, und die jeweilige Schnappkante 9 ist an einem radial äußeren Rand 1a des inneren Rosettenkörpers 1 ausgebildet, wie beispielsweise aus den Fig. 9 und 11 bis 18 ersichtlich.

In vorteilhaften Realisierungen ist am radial äußeren Rand 1a des inneren Rosettenkörpers 1, wie im Ausführungsbeispiel der Fig. 9 bis 18, axial vor der jeweiligen Schnappkante 9 eine Aufschnappkontur 11 ausgebildet, wie beispielsweise aus den Fig. 9 und 11 ersichtlich. Beim Montieren des äußeren Rosettenkörpers 2 am inneren Rosettenkörper 1 unterstützt die Aufschnappkontur 11 als entsprechende Schrägfläche am radial äußeren Rand 1a des inneren Rosettenkörpers 1 das radial elastische Biegen der jeweiligen Schnappnase 8, bevor dann die Schnappnase 8 hinterrastend hinter der Schnappkante 9 wieder zurückschnappt und dadurch den äußeren Rosettenkörper 2 axial am inneren Rosettenkörper 1 festhält. Unterstützend kann dazu auch die jeweilige Schnappnase 8, wie im Beispiel der Fig. 9 bis 18, mit einer kopfseitigen Aufrastschräge versehen sein.

Die Figuren veranschaulichen darüber hinaus zwei vorteilhafte Ausführungsformen des erfindungsgemäßen Installations-Einbausets, die in diesem Fall zum Einbau in eine wandeingebaute, sanitäre Installationsanschlussbox eingerichtet sind. Das Einbauset beinhaltet jeweils einen Funktionsblock 12 zum Einbau in die Installationsanschlussbox, die hier nicht weiter interessiert und von irgendeiner herkömmlichen Bauart sein kann, und eine Abdeckrosette erfindungsgemäßer Art. Der Funktionsblock 12 umfasst einen Grundkörper 13 und einen daran gehaltenen Abdeckkörper 14, wobei zumindest der innere Rosettenkörper 1 der Abdeckrosette Bestandteil des Funktionsblock-Abdeckkörpers 14 ist.

Die Fig. 1 bis 8 veranschaulichen ein Ausführungsbeispiel des Installations-Einbausets, bei dem der äußere Rosettenkörper 2 des Installations-Einbausets als ein Sicht-/Bedienoberflächenkörper 17 ausgebildet ist. Damit ist gemeint, dass der äußere Rosettenkörper 2 in diesem Fall das zur Benutzerseite bzw. Bedienseite hin äußerste Element des Einbausets darstellt, an dem je nach Ausführung des Funktionsblocks 12 noch zugehörige, vom Benutzer zu betätigende Bedienelemente, z.B. zur Betätigung eines jeweils zugehörigen Ventils, und/oder für den Benutzer sichtbare Bediensymbole, Anzeigesymbole und/oder Anzeigeelemente angeordnet werden.

Die Fig. 9 bis 18 veranschaulichen eine Ausführungsform des Installations-Einbausets, bei welcher der äußere Rosettenkörper 2 ein äußerer Bestandteil des Abdeckkörpers 14 des Funktionsblocks 12 ist und eine Befestigungsstruktur 16 zum Anbringen eines Sicht-/Bedienoberflächenkörpers aufweist, der hier nicht weiter von Interesse und daher nicht gezeigt ist. Bei diesem Sicht-/Bedienoberflächenkörper kann es sich beispielsweise um einen ähnlichen wie dem Sicht-/Bedienoberflächenkörper 17 des Ausführungsbeispiels der Fig. 1 bis 8 handeln. Die zugehörige Befestigungsstruktur 16 ist in einer für den ihr zugedachten Befestigungszweck geeigneten Weise ausgeführt, was hier keiner näheren Erläuterungen bedarf, z.B. unter Verwendung lösbarer Befestigungsmittel wie Schnapp- oder Schraubverbindungen.

Zur Montage des jeweiligen Installations-Einbausets wird zunächst der Funktionsblock 12 mit seinem Grundkörper 13 in eine Installationsanschlussbox, die zuvor in der betreffenden gebäudeseitigen Wandöffnung montiert wird, eingefügt und an dieser festgelegt. Der Abdeckkörper 14 befindet sich hierbei bereits montiert am Grundkörper 13 oder er wird erst danach an ihm montiert. Damit ist dann auch bereits der innere Rosettenkörper 1 am Grundkörper 13 festgelegt.

Nun wird der äußere Rosettenkörper 2 auf dem inneren Rosettenkörper 1 angebracht, indem er in den gezeigten Beispielen auf diesen axial aufgeschnappt wird. Alternativ kann der äußere Rosettenkörper 2 auch bereits auf dem inneren Rosettenkörper 1 angebracht sein, wenn letzterer mit dem Funktionsblock in der Installationsanschlussbox montiert wird. Abschließend wird der äußere Rosettenkörper 2 in seiner Winkellage bezüglich der Rosettenlängsachse L_{R} unter Nutzung der begrenzten Drehbeweglichkeit des äußeren Rosettenkörpers 2 um höchstens den vorgegebenen Winkelausgleichsbetrag dα in die gewünschte Soll-Winkellage α_{S} gegenüber dem inneren Rosettenkörper 1 gedreht.

Bei der in den Beispielen verwendeten Rechteckform des äußeren Rosettenkörpers 2 ist als Soll-Winkellage in der Regel gewünscht, dass seine Seitenkanten exakt horizontal bzw. vertikal orientiert sind. Um sicherzustellen, dass der äußere Rosettenkörper 2 diese Soll-Winkellage α_{S} einnimmt, auch wenn in Bezug hierzu der Funktionsblock 12 und damit auch der innere Rosettenkörper 1 verdreht montiert sind, braucht der Monteur bzw. Installateur somit keinerlei Nacharbeiten am Funktionsblock 12 und dem inneren Rosettenkörper 1 oder gar der Installationsanschlussbox und der gebäudeseitigen Wandöffnung vornehmen. Vielmehr genügt es, dass er den äußeren Rosettenkörper 2 in die gewünschte Soll-Winkellage α_{S} gegenüber dem inneren Rosettenkörper 1 dreht.

Wie die gezeigten und die weiteren oben erläuterten Ausführungsbeispiele deutlich machen, stellt die Erfindung eine Abdeckrosette zur Verfügung, mit der sich eine gebäudeseitige Wandöffnung sehr montagefreundlich abdecken lässt, wobei der für den Benutzer sichtbar bleibende Teil der Abdeckrosette in vorteilhaft einfacher Weise exakt in die gewünschte Winkellage bezüglich der Rosettenlängsachse und damit in seiner Orientierung in der Ebene der Oberfläche der Gebäudewand ausgerichtet werden kann.

Des Weiteren stellt die Erfindung in vorteilhafter Weise ein Installations-Einbauset zur Verfügung, das sich für Sanitärinstallationen und in gleicher Weise auch für Elektroinstallationen eignet und das durch die Verwendung der erfindungsgemäßen Abdeckrosette deren vorteilhafte Eigenschaften übernimmt, insbesondere hinsichtlich einer Abdeckung der betreffenden gebäudeseitigen Wandöffnung derart, dass der für den Benutzer sichtbar bleibende Teil des Einbausets in Form des äußeren Rosettenkörpers der Abdeckrosette selbst bei Fertigungs- und/oder Montageungenauigkeiten der innenliegenden Komponenten des Einbausets, wie des Grundkörpers und des Abdeckkörpers des Funktionsblocks, ohne großen Aufwand in seiner Winkellage an der Gebäudewand in Bezug auf die Rosettenlängsachse bzw. die Längsachse der gebäudeseitigen Wandöffnung exakt in eine gewünschte Orientierung ausgerichtet werden kann.

## Patentansprüche

1. Abdeckrosette zum Abdecken einer gebäudeseitigen Wandöffnung, insbesondere für ein wandeinbaubares sanitäres oder elektrisches Installations-Einbauset, mit
- einem inneren Rosettenkörper (1), der zur stationären wandseitigen Festlegung eingerichtet ist,
- einem äußeren Rosettenkörper (2) zum Anbringen auf dem inneren Rosettenkörper (1) und
- einer Befestigungsstruktur (3), mit welcher der äußere Rosettenkörper (2) um einen vorgebbaren Winkelausgleichsbetrag (dα) begrenzt drehbeweglich um eine Rosettenlängsachse (L_{R}) am inneren Rosettenkörper (1) gehalten ist,
**dadurch gekennzeichnet, dass**
- die Befestigungsstruktur (3) eine um den vorgebbaren Winkelausgleichsbetrag (dα) begrenzt drehbewegliche Schnappverbindung (4) des äußeren Rosettenkörpers (2) am inneren Rosettenkörper (1) umfasst und
- die Schnappverbindung (4) mindestens eine vom äußeren oder inneren Rosettenkörper (2, 1) axial abstehende Schnappnase (5) und eine mit dieser durchsteckend zusammenwirkende, schlitzförmige Schnappöffnung (6) im anderen Rosettenkörper (1, 2) umfasst, wobei in Rosettenumfangsrichtung eine Winkelerstreckung (6w) der Schnappöffnung (6) um den vorgebbaren Winkelausgleichsbetrag (dα) größer ist als eine Winkelerstreckung (5w) der Schnappnase (5) oder
- die Schnappverbindung (4) mindestens eine vom äußeren oder inneren Rosettenkörper (2, 1) radial abstehende Schnappnase (8) und eine mit dieser hinterrastend zusammenwirkende Schnappkante (9) am anderen Rosettenkörper (1, 2) umfasst, wobei in Rosettenumfangsrichtung seitlich einer Rückseite der Schnappkante (9) mindestens ein Drehbegrenzungsanschlag (10a, 10b) für die Schnappnase (8) ausgebildet ist.

2. Abdeckrosette nach Anspruch 1, weiter **dadurch gekennzeichnet, dass** die Befestigungsstruktur (3) die jeweilige Drehstellung des äußeren Rosettenkörpers (2) am inneren Rosettenkörper (1) durch eine nutzerüberwindbare Kraftschlussverbindung sichert.

3. Abdeckrosette nach Anspruch 1 oder 2, weiter **dadurch gekennzeichnet, dass** der innere Rosettenkörper (1) zur stationären Festlegung an einem Funktionsblock eines wandeinbaubaren sanitären Installations-Einbausets eingerichtet ist.

4. Abdeckrosette nach einem der Ansprüche 1 bis 3, weiter **dadurch gekennzeichnet, dass** der Winkelausgleichsbetrag (dα) zwischen 2° und 10° beträgt, insbesondere zwischen 4° und 8°, und sich aus einem ersten Winkelausgleichsbetragsanteil (dα1) in der einen Drehrichtung um die Rosettenlängsachse (L_{R}) gegenüber einer vorgegebenen Sollwinkellage (α_{S}) des äußeren Rosettenkörpers (2) und einem zweiten Winkelausgleichsbetragsanteil (dα2) in der anderen Drehrichtung um die Rosettenlängsachse (L_{R}) gegenüber der vorgegebenen Sollwinkellage (α_{S}) zusammensetzt.

5. Abdeckrosette nach einem der Ansprüche 1 bis 4, weiter **dadurch gekennzeichnet, dass** die Schnappnase (5) axial von einer Rückseite (2a) des äußeren Rosettenkörpers (2) absteht und die Schnappöffnung (6) am inneren Rosettenkörper (1) ausgebildet ist.

6. Abdeckrosette nach einem der Ansprüche 1 bis 5, weiter **dadurch gekennzeichnet, dass** die Schnappöffnung (6) von einer Dichtungsstruktur (7) umrandet ist.

7. Abdeckrosette nach einem der Ansprüche 1 bis 4, weiter **dadurch gekennzeichnet, dass** die Schnappnase (8) radial nach innen von einem radial inneren Rand (2b) des äußeren Rosettenkörpers (2) absteht und die Schnappkante (9) an einem radial äußeren Rand (1a) des inneren Rosettenkörpers (1) ausgebildet ist.

8. Abdeckrosette nach einem der Ansprüche 1 bis 4 oder nach Anspruch 7, weiter **dadurch gekennzeichnet, dass** am radial äußeren Rand (1a) des inneren Rosettenkörpers (1) axial vor der Schnappkante (9) eine Aufschnappkontur (11) ausgebildet ist.

9. Installations-Einbauset zum Einbau in eine wandeingebaute, sanitäre oder elektrische Installationsanschlussbox, mit
- einem Funktionsblock (12) zum Einbau in die Installationsanschlussbox, wobei der Funktionsblock (12) einen Grundkörper (13) und einen daran gehaltenen Abdeckkörper (14) aufweist,
**gekennzeichnet durch**
- eine Abdeckrosette nach einem der Ansprüche 1 bis 8, wobei zumindest der innere Rosettenkörper (1) Bestandteil des Funktionsblock-Abdeckkörpers (14) ist.

10. Installations-Einbauset nach Anspruch 9, weiter **dadurch gekennzeichnet, dass**
- der äußere Rosettenkörper (2) ein äußerer Bestandteil des Funktionsblock-Abdeckkörpers (14) ist und eine Befestigungsstruktur (16) zum Anbringen eines Sicht-/Bedienoberflächenkörpers aufweist oder
- der äußere Rosettenkörper (2) als ein Sicht-/Bedienoberflächenkörper (17) ausgebildet ist.

## Claims

1. Escutcheon for covering a wall opening of a building, preferably for a wall-mountable sanitary or electrical installation mounting kit, comprising
- an inner escutcheon body (1) configured for stationary wall fixing,
- an outer escutcheon body (2) for attachment on the inner escutcheon body (1), and
- a fastening structure (3) with which the outer escutcheon body (2) is held on the inner escutcheon body (1) rotatably to a limited extent about an escutcheon longitudinal axis (L_{R}) by a predefinable angular compensation amount (dα),
**characterized in that**
- the fastening structure (3) comprises a snap-on connection (4) of the outer escutcheon body (2) on the inner escutcheon body (1), the snap-on connection being rotatable to a limited extent by the predefinable angular compensation amount (dα), and
- the snap-on connection (4) comprises at least one snap-on lug (5) which axially protrudes from the outer or the inner escutcheon body (2, 1) and a slotted snap-on opening (6) in the other escutcheon body (1, 2) which cooperates with the lug in a plug-through fashion, wherein an angular extent (6w) of the snap-on opening (6) in peripheral direction of the escutcheon is greater than an angular extent (5w) of the snap-on lug (5) by the predefinable angular compensation amount (dα), or
- the snap-on connection (4) comprises at least one snap-on lug (8) which protrudes radially from the outer or the inner escutcheon body (2, 1) and a snap-on edge (9) on the other escutcheon body (1, 2) which cooperates with the lug in a rear-latching fashion, wherein at least one rotation-limiting stop (10a, 10b) is formed for the snap-on lug (8) lateral to a rear side (9a) of the snap-on edge (9) in peripheral direction of the escutcheon.

2. Escutcheon according to claim 1, further **characterized in that** the fastening structure (3) secures the respective rotational position of the outer escutcheon body (2) on the inner escutcheon body (1) using a user-releasable force-locked connection.

3. Escutcheon according to claim 1 or 2, further **characterized in that** the inner escutcheon body (1) is configured for stationary fixing on a functional block of a wall-mountable sanitary installation mounting kit.

4. Escutcheon according to any one of claims 1 to 3, further **characterized in that** the angular compensation amount (dα) is between 2° and 10°, preferably between 4° and 8°, and is made up of a first angular compensation amount portion (dα1) in one rotational direction about the escutcheon longitudinal axis (L_{R}) relative to a predefined target angular position (α_{S}) of the outer escutcheon body (2) and a second angular compensation amount portion (dα2) in the other rotational direction about the escutcheon longitudinal axis (L_{R}) relative to the predefined target angular position (α_{S}).

5. Escutcheon according to any one of claims 1 to 4, further **characterized in that** the snap-on lug (5) axially protrudes from a rear side (2a) of the outer escutcheon body (2) and that the snap-on opening (6) is formed on the inner escutcheon body (1).

6. Escutcheon according to any one of claims 1 to 5, further **characterized in that** the snap-on opening (6) is surrounded along an edge by a sealing structure (7).

7. Escutcheon according to any one of claims 1 to 4, further **characterized in that** the snap-on lug (8) radially protrudes inward from a radial inner edge (2a) of the outer escutcheon body (2) and that the snap-on edge (9) is formed on a radial outer edge (1a) of the inner escutcheon body (1).

8. Escutcheon according to any one of claims 1 to 4 or according to claim 7, further **characterized in that** a snap-on contour (11) is formed on the radial outer edge (1a) of the inner escutcheon body (1) axially in front of the snap-on edge (9).

9. Installation mounting kit for mounting in a wall-mounted sanitary or electrical installation connection box, comprising
- a functional block (12) for mounting in the installation connection box, wherein the functional block (12) comprises a base body (13) and a cover body (14) held thereon,
**characterized by**
- an escutcheon according to one of claims 1 to 8, wherein at least the inner escutcheon body (1) is a component of the functional block cover body (14).

10. Installation mounting kit according to claim 9, further **characterized in that**
- the outer escutcheon body (2) is an outer component of the functional block cover member (14) and comprises a fastening structure (16) for attachment of a visual interface/operating interface body or
- the outer escutcheon body (2) is formed as a visual interface/operating interface body (17).

## Revendications

1. Rosace de recouvrement pour recouvrir une ouverture murale côté bâtiment, notamment pour un kit d'installation sanitaire ou électrique encastrable dans le mur, avec
- un corps de rosace intérieur (1) qui est configuré pour l'application fixe côté mur,
- un corps de rosace extérieur (2) à poser sur le corps de rosace intérieur (1) et
- une structure de fixation (3) au moyen de laquelle le corps de rosace extérieur (2) est maintenu sur le corps de rosace intérieur (1) de manière à pouvoir tourner de façon limitée autour d'un axe longitudinal de la rosace (L_{R}), selon une valeur de compensation angulaire prédéfinissable (dα),
**caractérisée en ce que**
- la structure de fixation (3) comprend, sur le corps de rosace intérieur (1), une liaison à encliquetage (4) du corps de rosace extérieur (2), rotative de façon limitée selon la valeur de compensation angulaire prédéfinissable (dα), et
- que la liaison à encliquetage (4) comprend au moins un ergot d'encliquetage (5) faisant saillie axialement à partir du corps de rosace extérieur ou intérieur (2, 1), ainsi qu'une ouverture d'encliquetage (6) en forme de fente située dans l'autre corps de rosace (1, 2) et interagissant avec celui-ci par insertion traversante, sachant que dans le sens circonférentiel de la rosace, une étendue angulaire (6w) de l'ouverture d'encliquetage (6) est supérieure à une étendue angulaire (5w) de l'ergot d'encliquetage (5), de la valeur de compensation angulaire prédéfinissable (dα), ou
- que la liaison à encliquetage (4) comprend au moins un ergot d'encliquetage (8) faisant saillie radialement à partir du corps de rosace extérieur ou intérieur (2, 1), ainsi qu'une arête d'encliquetage (9) située dans l'autre corps de rosace (1, 2) et interagissant avec celui-ci par encliquetage arrière, sachant que dans le sens circonférentiel de la rosace, au moins une butée de limitation de rotation (10a, 10b) est formée pour l'ergot d'encliquetage (8) sur un côté d'une face arrière de l'arête d'encliquetage (9).

2. Rosace de recouvrement selon la revendication 1, caractérisée également en ce que la structure de fixation (3) bloque la position de rotation respective du corps de rosace extérieur (2) sur le corps de rosace intérieur (1) au moyen d'une liaison de force détachable par l'utilisateur.

3. Rosace de recouvrement selon la revendication 1 ou 2, caractérisée également en ce que le corps de rosace intérieur (1) est configuré pour l'application fixe sur un bloc fonctionnel d'un kit d'installation sanitaire encastrable dans le mur.

4. Rosace de recouvrement selon l'une des revendications 1 à 3, caractérisée également en ce que la valeur de compensation angulaire (dα) est comprise entre 2° et 10°, notamment entre 4° et 8°, et se compose d'une première part de la valeur de compensation angulaire (dα1) dans une des directions de rotation autour de l'axe longitudinal de la rosace (L_{R}) par rapport à une position angulaire de consigne prédéfinie (α_{S}) du corps de rosace extérieur (2) et d'une seconde part de la valeur de compensation angulaire (dα2) dans l'autre direction de rotation autour de l'axe longitudinal de la rosace (L_{R}) par rapport à la position angulaire de consigne prédéfinie (α_{S}).

5. Rosace de recouvrement selon l'une des revendications 1 à 4, caractérisée également en ce que l'ergot d'encliquetage (5) fait saillie axialement à partir d'une face arrière (2a) du corps de rosace extérieur (2) et que l'ouverture d'encliquetage (6) est formée sur le corps de rosace intérieur (1).

6. Rosace de recouvrement selon l'une des revendications 1 à 5, caractérisée également en ce que l'ouverture d'encliquetage (6) est entourée d'une structure d'étanchéité (7).

7. Rosace de recouvrement selon l'une des revendications 1 à 4, caractérisée également en ce que l'ergot d'encliquetage (8) fait saillie radialement vers l'intérieur, à partir d'un bord radialement intérieur (2b) du corps de rosace extérieur (2) et que l'arête d'encliquetage (9) est formée sur un bord radialement extérieur (1a) du corps de rosace intérieur (1).

8. Rosace de recouvrement selon l'une des revendications 1 à 4 ou selon la revendication 7, caractérisée également en ce qu'un contour d'encliquetage (11) est formé sur le bord radialement extérieur (1a) du corps de rosace intérieur (1), axialement en amont de l'arête d'encliquetage (9).

9. Kit d'installation pour l'encastrement dans un boîtier de raccordement d'installation sanitaire ou électrique encastré dans le mur, avec
- un bloc fonctionnel (12) pour l'encastrement dans le boîtier de raccordement d'installation, sachant que le bloc fonctionnel (12) présente un corps de base (13) et un corps de recouvrement maintenu dessus (14),
caractérisé en
- une rosace de recouvrement selon l'une des revendications 1 à 8, sachant qu'au moins le corps de rosace intérieur (1) fait partie du corps de recouvrement du bloc fonctionnel (14).

10. Kit d'installation selon la revendication 9, caractérisé également en ce que
- le corps de rosace extérieur (2) constitue un élément extérieur du corps de recouvrement du bloc fonctionnel (14) et présente une structure de fixation (16) destinée à la pose d'un corps formant une surface visible/de commande, ou
- que le corps de rosace extérieur (2) est conçu sous forme de corps formant une surface visible/de commande (17).
